# EUROPEAN PATENT APPLICATION

(11) **EP 4 760 278 A1**
(43) Date of publication of application: **17.06.2026**
(21) Application number: 25220629.7
(22) Date of filing: 04.12.2025
(51) Int. Cl.: G01R 27/18, G01R 31/52, H01M 10/42, G01R 27/02

(54) **ENERGY STORAGE SYSTEM AND INSULATION MONITORING METHOD FOR THE SAME**

(30) Priority: 12.12.2024 KR 20240184764
(71) Applicant: SAMSUNG SDI CO., LTD., Yongin-si, Gyeonggi-do 17084 (KR)
(72) Inventor: Kim, Sukki, 17084 Yongin-si, Gyeonggi-do (KR); Kim, Woochoul, 17084 Yongin-si, Gyeonggi-do (KR)
(74) Representative: Meissner Bolte Partnerschaft mbB

(57) **Abstract**

The present invention relates to an energy storage system (10) and an insulation monitoring method (S300) for the energy storage system (10). The energy storage system (10) includes a plurality of battery racks (100), each including a plurality of batteries and connected in parallel to one another, a power conversion device (110) connected to the plurality of battery racks (100) to convert power, a main switch (130) configured to turn on and off a current flow between the plurality of battery racks (100) and the power conversion device (110), a first insulation monitoring device (140) and a second insulation monitoring device (142) each connected to respective terminals of the main switch (130), and a controller (120) configured to control operations of the main switch (130), the first insulation monitoring device (140), and the second insulation monitoring device (142). The first insulation monitoring device (140) monitors insulation information regarding the power conversion device (110), and the second insulation monitoring device (142) monitors insulation information regarding the plurality of battery racks (100).

## Description

### FIELD

The present invention relates to an energy storage system and an insulation monitoring method for the energy storage system.

### BACKGROUND

Unlike primary batteries that are not designed to be (re)charged, secondary (or rechargeable) batteries are batteries that are designed to be discharged and recharged. Low-capacity secondary batteries are used in portable, small electronic devices, such as smart phones, feature phones, notebook computers, digital cameras, and camcorders, while large-capacity secondary batteries are widely used as power sources for driving motors in hybrid vehicles and electric vehicles and for storing power (e.g., home and/or utility scale power storage). A secondary battery generally includes an electrode assembly composed of a positive electrode and a negative electrode, a case accommodating the same, and electrode terminals connected to the electrode assembly.

Meanwhile, an energy storage system (ESS) may connect renewable energy sources such as wind power and solar power-which cannot control power generation output-to an existing power grid, and may charge or discharge energy in accordance with power consumption patterns. In particular, an energy storage system using secondary batteries not only may be used to stabilize a grid voltage and frequency but also may store surplus energy in connection with renewable energy generation systems such as wind power or solar power (where the amount of generated power is not constant) and discharge the energy stored in the battery to supply energy to a load.

In such an energy storage system, insulation resistance may be an important factor to ensure safe and efficient operation. If the insulation resistance is inadequate, an electrical issue may occur inside the battery system, which could possibly lead to a fire or system damage. In particular, because an energy storage system is composed of multiple battery racks and each battery rack may have a different insulation state, insulation failure arising in a specific battery rack can affect the entire system. Therefore, to enhance the stability of the energy storage system, there is a need for a method that can measure the insulation resistance of individual battery racks quickly and accurately, and respond immediately when a problem occurs.

The herein information disclosed in this background section is for enhancement of understanding of the background of the present invention, and therefore, it may contain information that does not constitute related (or prior) art.

### SUMMARY OF THE INVENTION

The present invention provides an energy storage system and an insulation monitoring method for the energy storage system to resolve the herein-described issues.

These and other aspects and features of the present invention will be described in or will be apparent from the following description of embodiments of the present invention.

According to the present invention for solving the technical problems, an energy storage system includes a plurality of battery racks that each contain a plurality of batteries and are connected in parallel with one another, a power conversion device connected to the plurality of battery racks and configured to convert power, a main switch configured to turn on and off a current flow between the plurality of battery racks and the power conversion device, a first insulation monitoring device and a second insulation monitoring device each connected to respective terminals of the main switch, and a controller configured to control operations of the main switch, the first insulation monitoring device, and the second insulation monitoring device. The first insulation monitoring device may monitor insulation information regarding the power conversion device, and the second insulation monitoring device may monitor insulation information regarding the plurality of battery racks.

According to embodiments of the present invention, the controller may control one of the first insulation monitoring device and the second insulation monitoring device to operate when the main switch is in a closed state.

According to embodiments of the present invention the controller may stop the operations of the first insulation monitoring device and the second insulation monitoring device for a predetermined time when the main switch is closed.

According to embodiments of the present invention, after the operations of the first and second insulation monitoring devices are stopped, the controller may control either the first insulation monitoring device or the second insulation monitoring device to operate after the predetermined time elapses.

According to embodiments of the present invention, after the operations of the first and second insulation monitoring devices are stopped, the controller may control the second insulation monitoring device to operate after the predetermined time elapses, and may control the first insulation monitoring device not to operate.

According to embodiments of the present invention, the energy storage system may further include a plurality of sub switches that are each connected to the plurality of battery racks and configured to turn on and off a current flow between the second insulation monitoring device and the plurality of battery racks, wherein each of the plurality of sub switches corresponds to each of the plurality of battery racks, and the controller may further control operations of the plurality of sub switches.

According to embodiments of the present invention, while the main switch is open, the controller may control operations of the plurality of sub switches and the second insulation monitoring device so as to monitor insulation information of each of the plurality of battery racks by sequentially closing the plurality of sub switches.

According to embodiments of the present invention, if the controller determines that an insulation state of a specific battery rack is abnormal, the controller may control a sub switch connected to the specific battery rack to open.

According to embodiments of the present invention, if the controller finishes monitoring the insulation information of the plurality of battery racks, the controller may control the main switch to close.

According to embodiments of the present invention, the energy storage system may further include a plurality of fuses each connected between a respective one of the plurality of battery racks and the main switch.

According to embodiments of the present invention, the energy storage system may further include a main positive circuit in which the positive terminals of the plurality of battery racks are connected in parallel, and a main negative circuit in which the negative terminals of the plurality of battery racks are connected in parallel, wherein the main positive circuit and the main negative circuit may be connected to the main switch.

According to embodiments of the present invention, the energy storage system may further include a plurality of sub positive circuits branched from the main positive circuit and connected respectively to the positive terminals of each of the plurality of battery racks, and a plurality of sub negative circuits branched from the main negative circuit and connected respectively to the negative terminals of each of the plurality of battery racks, wherein each of the plurality of sub positive circuits may be connected to a first sub switch, and each of the plurality of sub negative circuits may be connected to a second sub switch.

According to embodiments of the present invention, the energy storage system may further include a plurality of sub positive circuits branched from the main positive circuit and connected respectively to the positive terminals of each of the plurality of battery racks, and a plurality of sub negative circuits branched from the main negative circuit and connected respectively to the negative terminals of each of the plurality of battery racks, wherein each of the plurality of sub positive circuits may be connected to a first fuse, and each of the plurality of sub negative circuits may be connected to a second fuse.

According to the present invention for solving the technical problems, an insulation monitoring method includes monitoring an insulation state of a power conversion device that converts power by controlling operation of a first insulation monitoring device, monitoring an insulation state of a plurality of battery racks by controlling operation of a second insulation monitoring device, closing a main switch connected between the plurality of battery racks and the power conversion device in response to determining that the insulation states of the power conversion device and the plurality of battery racks are normal, and controlling one of the first insulation monitoring device or the second insulation monitoring device to operate.

According to embodiments of the present invention, the energy storage system may further include a plurality of sub switches that are each connected to the plurality of battery racks and configured to turn on and off a current flow between the second insulation monitoring device and the plurality of battery racks.

According to embodiments of the present invention, monitoring the insulation state of the plurality of battery racks may include sequentially closing the plurality of sub switches that are each connected to the plurality of battery racks, and monitoring the insulation state of a battery rack associated with any sub switch that is in a closed state.

According to embodiments of the present invention, monitoring the insulation state of the plurality of battery racks may further include controlling a sub switch associated with a specific battery rack to open if it is determined that the insulation state of the specific battery rack is abnormal.

According to embodiments of the present invention, after closing the main switch, the method may further include controlling operations of the first insulation monitoring device and the second insulation monitoring device so that they stop for a predetermined time.

According to embodiments of the present invention, controlling one of the first insulation monitoring device or the second insulation monitoring device to operate may include, after the operations of the first insulation monitoring device and the second insulation monitoring device are stopped for the predetermined time, controlling either the first insulation monitoring device or the second insulation monitoring device to operate.

According to embodiments of the present invention, controlling one of the first insulation monitoring device or the second insulation monitoring device to operate may include, after the operations of the first insulation monitoring device and the second insulation monitoring device are stopped for the predetermined time, controlling the second insulation monitoring device to operate and controlling the first insulation monitoring device not to operate.

According to some embodiments of the present invention, an energy storage system may include multiple insulation monitoring devices for monitoring insulation information of the system, and during an initial system build, the overall system may be classified by blocks, and an insulation monitoring device corresponding to each block may be used to efficiently monitor insulation information of each block.

According to some embodiments of the present invention, in a process of monitoring insulation information of multiple battery racks, the system may sequentially close multiple sub switches corresponding to the multiple battery racks so as to individually monitor the insulation information of the multiple battery racks. Through this configuration, it is possible to effectively monitor the insulation states of the battery racks and to detect effectively which battery rack among the multiple racks has an abnormal insulation state.

According to some embodiments of the present invention, in a case where multiple subsystems are connected into a single system by closing a main switch, the operations of the insulation monitoring device may be stopped for a predetermined time. Thus, it is possible to resolve the issue whereby parasitic impedance may suddenly change and cause the insulation information being monitored by the insulation monitoring device to be disturbed, thereby enabling the insulation information of the system to be effectively monitored.

However, aspects and features of the present invention are not limited to those described herein, and other aspects and features not mentioned will be clearly understood by a person skilled in the art from the detailed description, described herein.

### BRIEF DESCRIPTION OF THE DRAWINGS

The following drawings attached to this specification illustrate embodiments of the present invention and further describe aspects and features of the present invention together with the detailed description of the present invention. Thus, the present invention should not be construed as being limited to the drawings.
FIG. 1 illustrates a schematic diagram showing a configuration of an energy storage system according to embodiments of the present invention.
FIG. 2 illustrates a circuit diagram showing a configuration of an energy storage system according to embodiments of the present invention.
FIG. 3 illustrates a flowchart showing an example of an insulation monitoring method according to embodiments of the present invention.
FIG. 4 illustrates a circuit diagram showing a configuration of an energy storage system according to embodiments of the present invention.
FIG. 5 illustrates a flowchart providing details of step S320 of FIG. 3 according to embodiments of the present invention.
FIG. 6 illustrates a flowchart for explaining a process after a main switch is closed, according to embodiments of the present invention.
FIG. 7 illustrates a flowchart for explaining a process after a main switch is closed, according to embodiments of the present invention.
FIG. 8 illustrates a circuit diagram showing a configuration of an energy storage system according to embodiments of the present invention.
FIG. 9 illustrates a perspective view of a battery rack according to embodiments of the present invention.
FIG. 10 illustrates a perspective view of a battery module according to embodiments of the present invention.

### DETAILED DESCRIPTION

Hereinafter, embodiments of the present invention will be described in detail with reference to the accompanying drawings. The terms or words used in the present specification and claims are not to be limitedly interpreted as general or dictionary meanings and should be interpreted as meanings and concepts that are consistent with the technical idea of the present invention on the basis of the principle that an inventor can be his/her own lexicographer to appropriately define concepts of terms to describe his/her invention in the best way. Therefore, the embodiments described in this specification and the configurations shown in the drawings are only some of the embodiments of the present invention and do not represent all of the technical scope, aspects, and features of the present invention. Accordingly, it should be understood that there may be various equivalents and modifications that can replace or modify the embodiments described herein at the time of filing this application.

Also, it will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, in the figures, dimensions of the various elements, layers, etc. may be exaggerated for clarity of illustration. The same reference numerals designate the same elements.

References to two compared elements, features, etc. as being "the same" may mean that they are "substantially the same." Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

It will be understood that, although the terms first, second, etc. may be used herein to describe various elements, these elements should not be limited by these terms. These terms are only used to distinguish one element from another element. Thus, a first element could be termed a second element unless the context clearly indicates otherwise.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked," or "connected" to one another, or another component may be "interposed" between the components. It will also be understood that when an element is referred to as being "electrically coupled" to another element, it may be directly coupled to the other element or intervening elements may be present.

Throughout the specification, when "A and/or B" is stated, it means A, B, or A and B, unless otherwise stated. That is, "and/or" includes any or all combinations of a plurality of items enumerated. When "C to D" is stated, it means C or more and D or less, unless otherwise specified.

The terminology used herein is for the purpose of describing embodiments of the present invention and is not intended to be limiting of the present invention.

In this specification, expressions in the singular number include the plural unless they are clearly specified as singular in context. Likewise, expressions in the plural include the singular unless they are clearly specified as plural in context. Throughout this specification, when a portion is described as including a certain component, this means that the portion may further include another component, unless there is a specific statement to the contrary that excludes the other component.

In addition, as used in this specification, the terms "module" or "unit" refer to a software or hardware component that performs certain roles. However, the terms "module" or "unit" are not limited solely to software or hardware. A "module" or "unit" may be configured to be included in an addressable storage medium and to reproduce one or more processors. Thus, a "module" or a "unit" may include at least one of software components (e.g., object-oriented software components, class components, task components) and processes, functions, attributes, procedures, subroutines, program code segments, drivers, firmware, microcode, circuits, data, databases, data structures, tables, arrays, or variables. The functions within these components and "modules" or "units" may be combined into a smaller number of components, "modules," or "units," or may be further separated into additional components, "modules," or "units."

According to embodiments of the present invention, a "module" or "unit" may be implemented by a processor and a memory. The term "processor" should be broadly interpreted to include a general-purpose processor, a central processing unit (CPU), a microprocessor, a digital signal processor (DSP), a controller, a microcontroller, a state machine, and the like. In some environments, the term "processor" may refer to an application specific integrated circuit (ASIC), a programmable logic device (PLD), a field-programmable gate array (FPGA), etc. A "processor" may also refer to a combination of processing devices, such as a combination of a DSP and a microprocessor, a combination of multiple microprocessors, a combination of one or more microprocessors combined with a DSP core, or any other similar configuration. In addition, the term "memory" should be broadly interpreted to include any electronic component capable of storing electronic information. A "memory" may refer to various types of processor-readable media such as random access memory (RAM), read-only memory (ROM), nonvolatile random access memory (NVRAM), programmable read-only memory (PROM), erasable programmable read-only memory (EPROM), electrically erasable PROM (EEPROM), flash memory, magnetic or optical data storage devices, registers, or the like. When a processor can read information from and/or write information to a memory, the memory is said to be in electronic communication with the processor. A memory integrated into a processor is in electronic communication with the processor.

In the present invention, sizes and relative sizes of illustrated regions in the drawings may be exaggerated for clarity of explanation. That is, sizes shown in the drawings are merely for ease of understanding and are not limiting. In addition, any flowchart or associated description depicted in the drawings is merely an example, and may be implemented differently in some embodiments. For example, one or more steps may be omitted, the order of each step may be changed, one or more steps may overlap, or one or more steps may be repeated multiple times.

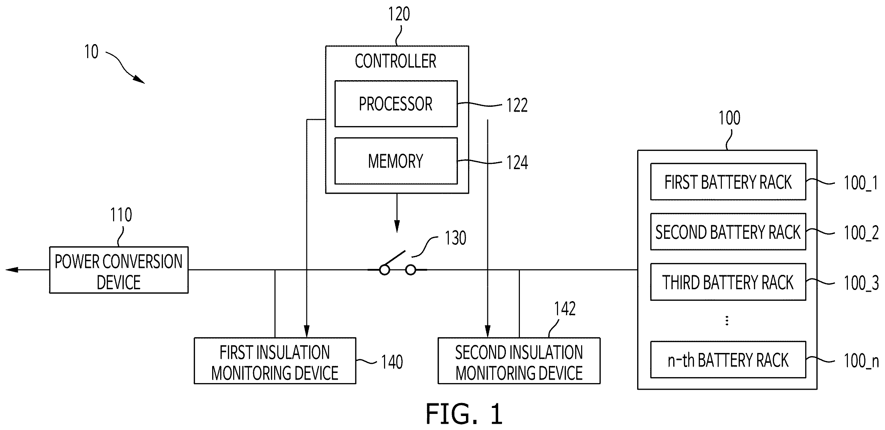

FIG. 1 illustrates a schematic diagram showing a configuration of an energy storage system 10 according to embodiments of the present invention. Referring to FIG. 1, the energy storage system 10 may include a plurality of battery racks 100, a power conversion device 110, a controller 120, a main switch 130, a first insulation monitoring device 140, and a second insulation monitoring device 142.

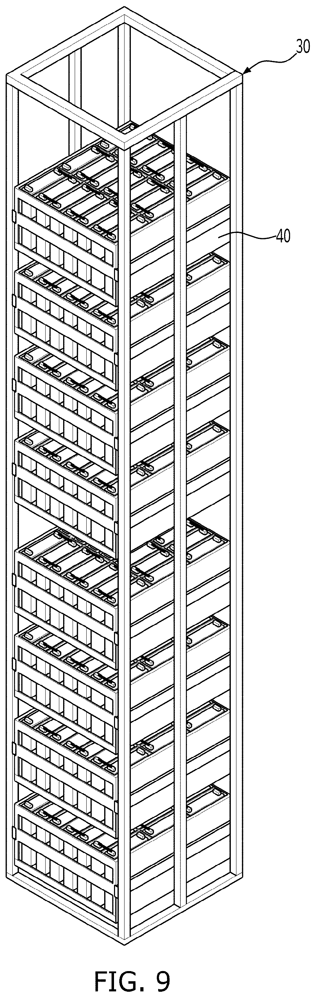

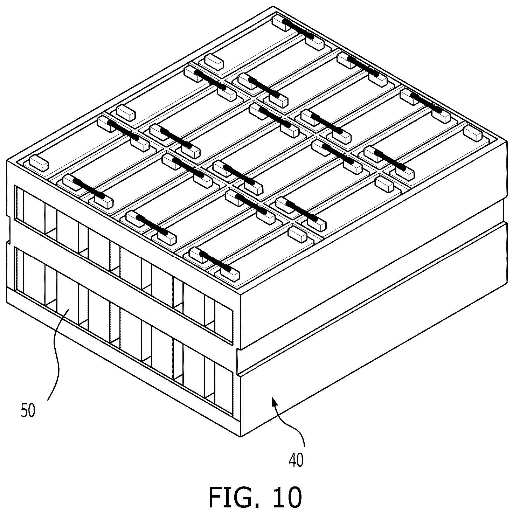

The plurality of battery racks 100 may each include a plurality of battery cells and may be connected in parallel with one another. Each of the plurality of battery racks 100 may include a battery module that includes a plurality of battery cells. The battery module may connect the plurality of battery cells in series via a plurality of connection terminals. Based on the electrical energy stored in the battery modules and/or battery cells included in each of the battery racks 100, the energy storage system 10 may store electrical energy supplied from an external grid or may discharge electrical energy stored in the energy storage system 10 to supply power to the external grid. A description of the configuration of the battery rack 100 will be provided herein with reference to FIGS. 9 and 10.

A power conversion device (PCS) 110 may be connected to the plurality of battery racks 100 and may convert power received from the plurality of battery racks 100. In addition, the power conversion device 110 may convert power supplied from an external grid to supply same to the plurality of battery racks 100. Specifically, the power conversion device 110 may convert direct current (DC) power generated by the battery racks 100 into alternating current (AC), or convert AC power supplied from an external grid into DC to charge the batteries included in the plurality of battery racks. In this way, the energy storage system 10 may meet various power demands and may enable efficient storage and supply of energy. The plurality of battery racks 100 are connected in parallel, and a circuit (for example, a connection line) connected to the parallel battery racks 100 may converge at a point that is connected to the power conversion device 110.

A controller 120 may control operations of individual components of the energy storage system 10. For example, to perform the insulation monitoring method described in some embodiments of the present invention, the controller 120 may control operations of the main switch, the first insulation monitoring device, and the second insulation monitoring device. Additionally, although not shown, the controller 120 may control operations of, and transmit/receive signals or information with the individual components, including the battery racks 100 and the power conversion device 110, of the energy storage system 10. Within the energy storage system 10, the controller 120 may be collectively referred to as an energy management system (EMS), a power management system (PMS), a battery management system (BMS), or similar designations.

The controller 120 may include a processor 122 and a memory 124. However, it is not limited to these components. The controller 120 may include additional components apart from the processor 122 and the memory 124. The processor 122 should be broadly interpreted to include a general-purpose processor, a central processing unit (CPU), a microprocessor, a digital signal processor (DSP), a controller, a microcontroller, a state machine, and the like. In some environments, the processor 122 may refer to an ASIC, a programmable logic device (PLD), an FPGA, and so on. For example, the processor 122 may refer to a combination of processing devices such as a DSP and a microprocessor, a combination of multiple microprocessors, or a combination of one or more microprocessors combined with a DSP core, or any other similar configuration.

The processor 122 may be configured to handle commands of a computer program by performing fundamental arithmetic, logic, and input/output operations. According to some embodiments of the present invention, the processor 122 may receive insulation information about the energy storage system 10 from the first insulation monitoring device 140 and/or the second insulation monitoring device 142. Moreover, based on the insulation information received from the first insulation monitoring device 140 and/or the second insulation monitoring device 142, the processor 122 may determine an insulation state of the energy storage system 10 and transmit a control signal for controlling operations of individual components of the energy storage system 10.

The memory 124 should be broadly interpreted to include any electronic component capable of storing electronic information. The memory 124 may refer to various types of processor-readable media, such as RAM, ROM, NVRAM, PROM, EPROM, EEPROM, flash memory, magnetic or optical data storage devices, registers, and the like. If the processor 122 can read information from and/or write information to the memory 124, the memory 124 is said to be in electronic communication with the processor 122. A memory integrated into the processor 122 is in electronic communication with the processor 122.

In embodiments, the memory 124 may include a non-transitory computer-readable recording medium. In embodiments, the memory 124 may include a permanent mass storage device. By another example, the permanent mass storage device may be separate from the memory 124 and may be included in a device that is contained in or wired/wirelessly accessible by the energy storage system 10. In yet another example, the memory 124 may be implemented within the processor 122.

According to embodiments, the memory 124 may store an operating system and at least one program code (for example, program code for monitoring insulation information and controlling operations). The memory 124 may also store insulation information about the energy storage system 10 received from the first insulation monitoring device 140 and/or the second insulation monitoring device 142. Furthermore, the memory 124 may store information relating to the insulation state of the energy storage system 10 (for example, information indicating normal/abnormal insulation states), which may be received from the processor 122 and/or from the insulation monitoring devices 140, 142.

A main switch 130 may turn on and off a current flow between the plurality of battery racks 100 and the power conversion device 110. That is, the plurality of battery racks 100 and the power conversion device 110 may exchange electrical energy via the main switch 130. Also, the main switch 130 may receive control signals from the controller 120. In response to receiving the control signal, the main switch 130 may turn on or off the current flow between the plurality of battery racks 100 and the power conversion device 110.

Insulation monitoring devices 140 and 142 may continuously monitor an electrical insulation state of the energy storage system 10 in order to ensure safe operation. The insulation monitoring devices 140 and 142 may monitor whether high-voltage components such as the power conversion device 110 or the battery racks 100 are properly insulated from the outside, and if an insulation failure occurs, the insulation monitoring devices 140 and 142 may immediately detect it to maintain electrical safety of the energy storage system 10.

In the energy storage system 10, multiple insulation monitoring devices may be included, such as the first insulation monitoring device 140 and the second insulation monitoring device 142. The first insulation monitoring device 140 may monitor an insulation state related to the power conversion device 110 and, for example, may detect an insulation defect that can occur in the process of converting DC to AC. By means of such monitoring, the energy storage system 10 may reduce the possibility of electrical loss or system failure during power conversion and maintain a safe connection to an external power grid. The second insulation monitoring device 142 may monitor an insulation state of the battery racks 100. Because the plurality of battery racks 100 are connected in parallel, each battery rack 100 must maintain a good insulation state in order for the energy storage system 10 to operate safely. By detecting, in real time, leakage current or insulation damage that can occur in the batteries, the second insulation monitoring device 142 may prevent accidents such as fire or explosion.

The first insulation monitoring device 140 and the second insulation monitoring device 142 may work in conjunction with the controller 120 so that if any problem arises in the insulation state of the energy storage system 10, a signal is sent to the controller 120 to protect the energy storage system 10. Alternatively, the controller 120 may determine the insulation state of the energy storage system 10 based on insulation information received from the first insulation monitoring device 140 and/or the second insulation monitoring device 142, and may protect the energy storage system 10 by controlling operations of each component.

Although two insulation monitoring devices are shown in FIG. 1, the energy storage system 10 according to some embodiments of the present invention is not limited thereto. That is, an energy storage system 10 according to some embodiments of the present invention may include three or more insulation monitoring devices.

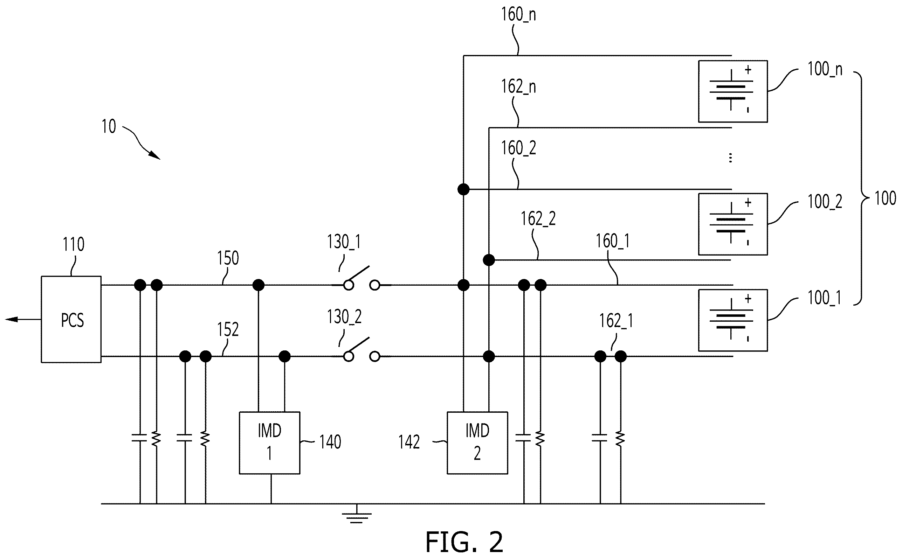

FIG. 2 illustrates a circuit diagram showing a configuration of the energy storage system 10 according to embodiments of the present invention. Referring to FIG. 2, the energy storage system 10 may include a plurality of battery racks 100, a power conversion device 110, a controller 120, a main switch 130, a first insulation monitoring device 140, a second insulation monitoring device 142, a main positive (+) circuit 150, a main negative (-) circuit 152, a sub (+) circuit 160, and a sub (-) circuit 162. Here, the main switch 130 may include a first main switch 130_1 and a second main switch 130_2. However, the main switch 130 may be a single switch or may include three or more switches, and there is no limitation thereto. In addition, the sub (+) circuit 160 may include multiple sub (+) circuits 160 each connected to a respective one of the plurality of battery racks 100, and the sub (-) circuit 162 may include multiple sub (-) circuits 162 each connected to a respective one of the plurality of battery racks 100. For example, a first sub (+) circuit 160_1 may correspond to a first battery rack 100_1, a second sub (+) circuit 160_2 may correspond to a second battery rack 100_2, and an n-th sub (+) circuit 160_n may correspond to an n-th battery rack 100_n. Likewise, a first sub (-) circuit 162_1 may correspond to the first battery rack 100_1, a second sub (-) circuit 162_2 may correspond to the second battery rack 100_2, and an n-th sub (-) circuit 162_n may correspond to the n-th battery rack 100_n.

In embodiments, the (+) output terminals of the plurality of battery racks 100 may be connected in parallel and connected to the main (+) circuit 150. In addition, the main (+) circuit 150 may be connected to the first main switch 130_1. Likewise, the (-) output terminals of the plurality of battery racks 100 may be connected in parallel and connected to the main (-) circuit 152. In addition, the main (-) circuit 152 may be connected to the second main switch 130_2. Because the power conversion device 110 and the plurality of battery racks 100 are connected across the main switch 130, current flowing between the power conversion device 110 and the plurality of battery racks 100 may circulate via the main (+) circuit 150 and the main (-) circuit 152. In this context, the main switch 130 may turn on and off the current flow between the plurality of battery racks 100 and the power conversion device 110.

In embodiments, the energy storage system 10 may further include the plurality of sub (+) circuits 160 branched from the main (+) circuit 150 and connected respectively to the (+) terminals of each of the plurality of battery racks 100, and the plurality of sub (-) circuits 162 branched from the main (-) circuit 152 and connected respectively to the (-) terminals of each of the plurality of battery racks 100. Through the plurality of sub (+) circuits 160 and the plurality of sub (-) circuits 162, current flowing through the main (+) circuit 150 and the main (-) circuit 152 may be branched so as to circulate through each of the plurality of battery racks 100.

In embodiments, a (not illustrated) controller may control only one of the first insulation monitoring device 140 and the second insulation monitoring device 142 to operate when the main switch 130 is in a closed state. In the circuit diagram shown in FIG. 2, if the main switch 130 is open, the first insulation monitoring device 140 monitors insulation information regarding the power conversion device 110, and the second insulation monitoring device 142 monitors insulation information regarding the plurality of battery racks 100. In that situation, when the main switch 130 is closed, the controller may control one of the first insulation monitoring device 140 and the second insulation monitoring device 142 to operate. If the main switch 130 is closed, the power conversion device 110 and the plurality of battery racks 100 are connected, and even if only one of the first insulation monitoring device 140 or the second insulation monitoring device 142 is operating, the insulation information in the system may still be smoothly monitored. In addition, once the entire system is connected, interference between the insulation monitoring devices may occur, causing the monitored insulation information to become inaccurate. Therefore, if the main switch 130 is closed, the controller may control only one of the first insulation monitoring device 140 and the second insulation monitoring device 142 to operate.

In embodiments, if the main switch 130 is closed, the controller may stop operation of the first insulation monitoring device 140 and the second insulation monitoring device 142 for a predetermined time. As described herein, if the main switch 130 is open, the first insulation monitoring device 140 monitors insulation information regarding the power conversion device 110, and the second insulation monitoring device 142 monitors insulation information regarding the plurality of battery racks 100. When multiple subsystems are connected into one by closing the main switch 130, the impedance of each subsystem may suddenly change. For example, parasitic impedance may abruptly change, and the insulation information monitored via the first insulation monitoring device 140 or the second insulation monitoring device 142 may be subject to interference. To address such problems, in some embodiments of the present invention, if the main switch 130 is closed, the controller may stop the operations of the first insulation monitoring device 140 and the second insulation monitoring device 142 for a predetermined time. Here, the predetermined time may range from a few seconds to a few minutes, without limitation in the present invention.

In embodiments, starting from the point in time at which the operations of the first insulation monitoring device 140 and the second insulation monitoring device 142 are stopped, the controller may control only one of the first insulation monitoring device 140 or the second insulation monitoring device 142 to operate after the predetermined time has elapsed. At this time, the controller may control the second insulation monitoring device 142 to operate and the first insulation monitoring device 140 not to operate. However, the present invention is not limited thereto. Thus, the controller may alternatively control the first insulation monitoring device 140 to operate and the second insulation monitoring device 142 not to operate.

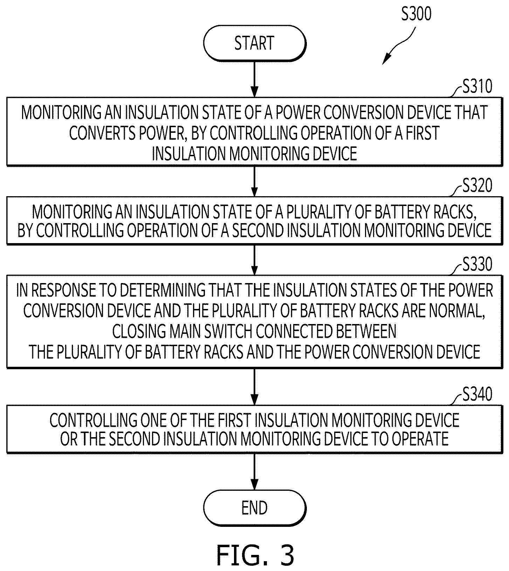

FIG. 3 illustrates a flowchart (S300) showing an example of an insulation monitoring method according to embodiments of the present invention. The insulation monitoring method (S300) may be performed by at least one processor (for example, the processor 122 of FIG. 1).

First, the insulation monitoring method (S300) may begin by monitoring an insulation state of a power conversion device that converts power, by controlling operation of a first insulation monitoring device (S310). After that, by controlling operation of a second insulation monitoring device, the processor may monitor an insulation state of a plurality of battery racks (S320). Here, a main switch that turns on and off a current flow between the plurality of battery racks and the power conversion device may be open. Therefore, when the main switch is open, the first insulation monitoring device and the second insulation monitoring device may operate independently to monitor the insulation states of the power conversion device and the plurality of battery racks, respectively.

After that, in response to determining that the insulation states of the power conversion device and the plurality of battery racks are normal, the processor may close the main switch connected between the plurality of battery racks and the power conversion device (S330). Then, the processor may control only one of the first insulation monitoring device or the second insulation monitoring device to operate (S340). In this way, if the main switch is in a closed state, only one of the first insulation monitoring device or the second insulation monitoring device may operate, so as to monitor the insulation state of the overall system without causing interference between multiple insulation monitoring devices.

The flowchart of FIG. 3 and the herein description are merely an example of the present invention, and the scope of the present invention is not limited thereto. For example, one or more of the steps of the flowchart and the herein description may be added/changed/deleted, the order of one or more steps may be changed, and one or more steps may be performed simultaneously.

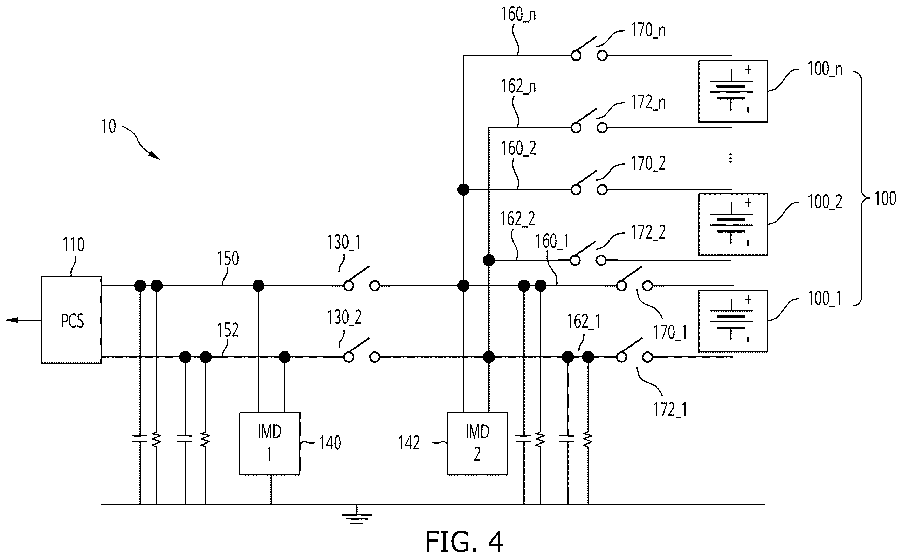

FIG. 4 illustrates a circuit diagram showing a configuration of the energy storage system 10 according to embodiments of the present invention. Referring to FIG. 4, the energy storage system 10 may include a plurality of battery racks 100, a power conversion device 110, a controller 120, a main switch 130, a first insulation monitoring device 140, a second insulation monitoring device 142, a main (+) circuit 150, a main (-) circuit 152, a sub (+) circuit 160, and a sub (-) circuit 162. Here, the main switch 130 may include the first main switch 130_1 and the second main switch 130_2. In addition, the sub (+) circuit 160 may include multiple sub (+) circuits 160 each connected to a respective one of the plurality of battery racks 100, and the sub (-) circuit 162 may include multiple sub (-) circuits 162 each connected to a respective one of the plurality of battery racks 100. For ease of explanation, features different from those described with reference to FIG. 2 will be emphasized.

In embodiments, the energy storage system 10 may further include a plurality of first sub switches 170 and a plurality of second sub switches 172, each connected to the plurality of battery racks 100, and configured to turn on and off a current flow between the second insulation monitoring device 142 and the plurality of battery racks 100.

Here, each of the plurality of first sub switches 170 and each of the plurality of second sub switches 172 may correspond to each of the plurality of battery racks 100. For example, a first sub switch 170_1 may correspond to a first battery rack 100_1, a first sub switch 170_2 may correspond to a second battery rack 100_2, and a first sub switch 170_n may correspond to an n-th battery rack 100_n. Likewise, a second sub switch 172_1 may correspond to the first battery rack 100_1, a second sub switch 172_2 may correspond to the second battery rack 100_2, and a second sub switch 172_n may correspond to the n-th battery rack 100_n.

In addition, each of the plurality of first sub switches 170 and each of the plurality of second sub switches 172 may be connected respectively to each of the plurality of sub (+) circuits 160 and each of the plurality of sub (-) circuits 162. For instance, the first sub switch 170_1 may be connected to the first sub (+) circuit 160_1, the first sub switch 170_2 may be connected to the second sub (+) circuit 160_2, and the first sub switch 170_n may be connected to the n-th sub (+) circuit 160_n. Likewise, the second sub switch 172_1 may be connected to the first sub (-) circuit 162_1, the second sub switch 172_2 may be connected to the second sub (-) circuit 162_2, and the second sub switch 172_n may be connected to the n-th sub (-) circuit 162_n.

In embodiments, when the main switch 130, the plurality of first sub switches 170, and the plurality of second sub switches 172 are in an open state, by sequentially closing the plurality of first sub switches 170 and the plurality of second sub switches 172, the controller may control the operations of the plurality of first sub switches 170, the plurality of second sub switches 172, and the second insulation monitoring device 142 so that the insulation information of each of the plurality of battery racks 100 is monitored. For example, when the plurality of first sub switches 170 and the plurality of second sub switches 172 are in the open state, the controller may close the first sub switch 170_1 and the second sub switch 172_1 to monitor insulation information of the first battery rack 100_1. After that, if the controller determines that the insulation state of the first battery rack 100_1 is normal, the controller may close the first sub switch 170_2 and the second sub switch 172_2 to monitor insulation information of the second battery rack 100_2. After that, if the controller determines that the insulation state of the (n-1)-th battery rack 100_(n-1) is normal, the controller may close the first sub switch 170_n and the second sub switch 172_n to monitor insulation information of the n-th battery rack 100_n. In this way, by sequentially closing the plurality of first sub switches 170 and the plurality of second sub switches 172, the controller may monitor the insulation information of each of the plurality of battery racks 100. At that time, when monitoring the insulation information of the n-th battery rack 100_n, the controller may reopen the first sub switch 170_n and the second sub switch 172_n after finishing that monitoring if it needs to monitor the insulation information of subsequent battery racks. Conversely, the controller may also keep the first sub switch 170_n and the second sub switch 172_n in the closed state when monitoring the insulation information of subsequent battery racks.

In embodiments, if the controller determines that the insulation state of the n-th battery rack 100_n is abnormal, the controller may control the first sub switch 170_n and the second sub switch 172_n connected to the n-th battery rack 100_n to open. Through such a process, by sequentially closing the plurality of first sub switches 170 and the plurality of second sub switches 172 and thus monitoring the insulation information of the plurality of battery racks 100, it is possible to effectively monitor the insulation states of the plurality of battery racks 100.

In embodiments, if the controller completes monitoring of the insulation information of the plurality of battery racks 100, the controller may control the main switch 130 to close.

In some embodiments of the present invention, the energy storage system 10 may be set up such that, during an initial build of the system, the overall system is divided by blocks, and each block's insulation information is monitored using the insulation monitoring device that corresponds to that block. As an example of such an approach, the first insulation monitoring device 140 may be used to monitor insulation information regarding the power conversion device 110, and the second insulation monitoring device 142 may be used to monitor insulation information regarding the plurality of battery racks 100. Subsequently, as described with reference to FIG. 2, by closing the main switch 130, the controller may monitor insulation information of the entire system using only one insulation monitoring device. With such a configuration, the insulation information within the entire system may be smoothly monitored without being affected by any interference between the insulation monitoring devices.

Also, while monitoring insulation information regarding the plurality of battery racks 100 via the second insulation monitoring device 142, the controller may sequentially close the plurality of first sub switches 170 and the plurality of second sub switches 172 in order to monitor the insulation information of the plurality of battery racks 100. Through this configuration, it is possible to effectively monitor the insulation states of the plurality of battery racks 100 and to effectively detect which battery rack 100 among the multiple racks has an abnormal insulation state.

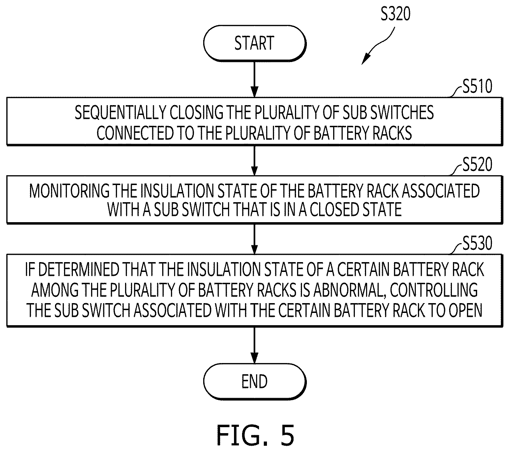

FIG. 5 illustrates a flowchart providing details of step S320 of FIG. 3. Step S320 may be performed by at least one processor (for example, the processor 122 of FIG. 1). Here, step S320 refers to monitoring the insulation state of a plurality of battery racks by controlling operation of a second insulation monitoring device.

First, step S320 may begin with sequentially closing the plurality of sub switches connected to the plurality of battery racks (S510). After that, the processor may monitor the insulation state of the battery rack associated with a sub switch that is in a closed state (S520). Then, if the processor determines that the insulation state of a certain battery rack among the plurality of battery racks is abnormal, the processor may control the sub switch associated with the certain battery rack to open (S530). For example, if the main switch, the plurality of first sub switches, and the plurality of second sub switches are open, the processor may close the first sub switch and the second sub switch associated with a first battery rack in order to monitor insulation information of the first battery rack. If the processor then determines that the insulation state of the first battery rack is normal, the processor may close the first sub switch and the second sub switch associated with a second battery rack in order to monitor insulation information of the second battery rack. Conversely, if the processor determines that the insulation state of the first battery rack is abnormal, the processor may control the first sub switch and the second sub switch associated with that first battery rack to open. In this manner, the processor may continue sequentially closing the plurality of sub switches and monitoring the insulation states of the associated battery racks until the insulation information of all battery racks has been monitored. At that time, when the processor closes sub switches associated with the n-th battery rack to monitor its insulation information, it may reopen them afterward if it needs to monitor a subsequent battery rack. Alternatively, the controller may maintain the sub switches for the n-th battery rack in the closed state even when monitoring subsequent battery racks.

The flowchart of FIG. 5 and the herein description are merely an example of the present invention, and the scope of the present invention is not limited thereto. For example, one or more of the steps of the flowchart or the herein description may be added/changed/deleted, the order of one or more steps may be changed, and one or more steps may be performed simultaneously.

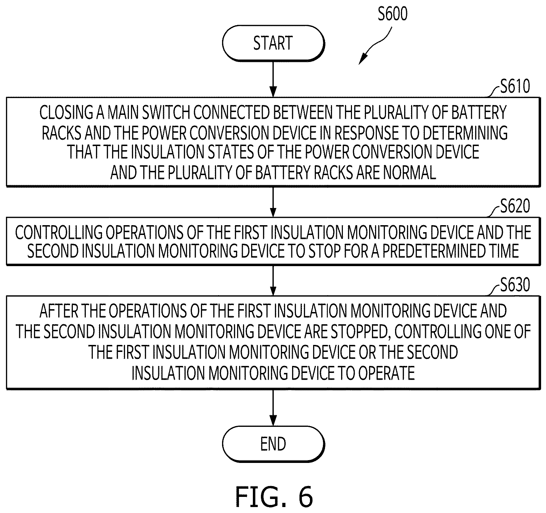

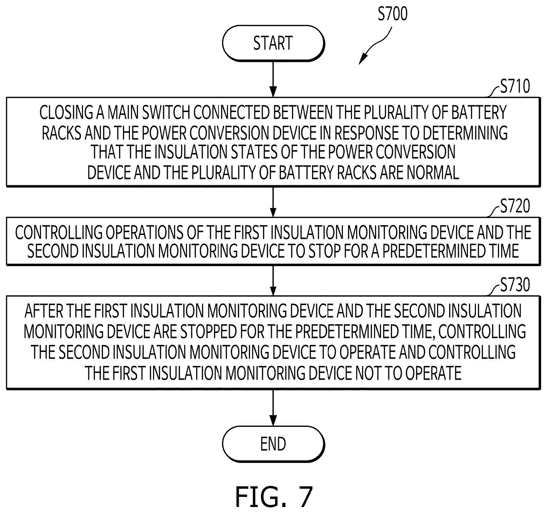

FIG. 6 illustrates a flowchart for explaining a process after a main switch is closed according to embodiments of the present invention. FIG. 7 illustrates a flowchart for explaining a process after a main switch is closed according to embodiments of the present invention. The methods (S600, S700) may be performed by at least one processor (for example, the processor 122 of FIG. 1).

Referring to FIG. 6, the method (S600) may begin by closing the main switch in response to determining that the insulation states of the power conversion device and the plurality of battery racks are normal (S610). Here, the main switch may be connected to the plurality of battery racks and the power conversion device. After that, the processor may control operations of the first insulation monitoring device and the second insulation monitoring device to stop for a predetermined time (S620). Here, the predetermined time may be the time needed for the system to stabilize and may be a few seconds to a few minutes. However, the present invention is not limited to that range. Starting from the point in time that the operations of the first insulation monitoring device and the second insulation monitoring device are stopped, the processor may then control one of the first insulation monitoring device or the second insulation monitoring device to operate after the predetermined time elapses (S630). The present invention may stop the operation of the insulation monitoring devices for a predetermined time when the main switch is closed in order to address the problem in which parasitic impedance may abruptly change and interfere with insulation information monitored by the insulation monitoring devices.

Referring to FIG. 7, the method (S700) may include closing the main switch in response to determining that the insulation states of the power conversion device and the plurality of battery racks are normal (S710), and controlling operations of the first insulation monitoring device and the second insulation monitoring device so that they both stop for a predetermined time (S720). Up to this point, the process may be identical to that shown in FIG. 6.

Subsequently, the processor may, after the first insulation monitoring device and the second insulation monitoring device are stopped for the predetermined time, control the second insulation monitoring device to operate and control the first insulation monitoring device not to operate (S730). The problem of parasitic impedance changing abruptly when the main switch is closed may be more likely to occur in the circuit associated with the plurality of battery racks. Therefore, according to embodiments of the present invention, the second insulation monitoring device associated with the plurality of battery racks may be operated first to monitor the insulation information of the plurality of battery racks, while operation of the other insulation monitoring device remains stopped.

The flowcharts of FIGS. 6 and 7 and the herein descriptions are merely examples of the present invention, and the scope of the present invention is not limited thereto. For example, one or more of the steps of the flowcharts and the herein descriptions may be added/changed/deleted, the order of one or more steps may be changed, and one or more steps may be performed simultaneously.

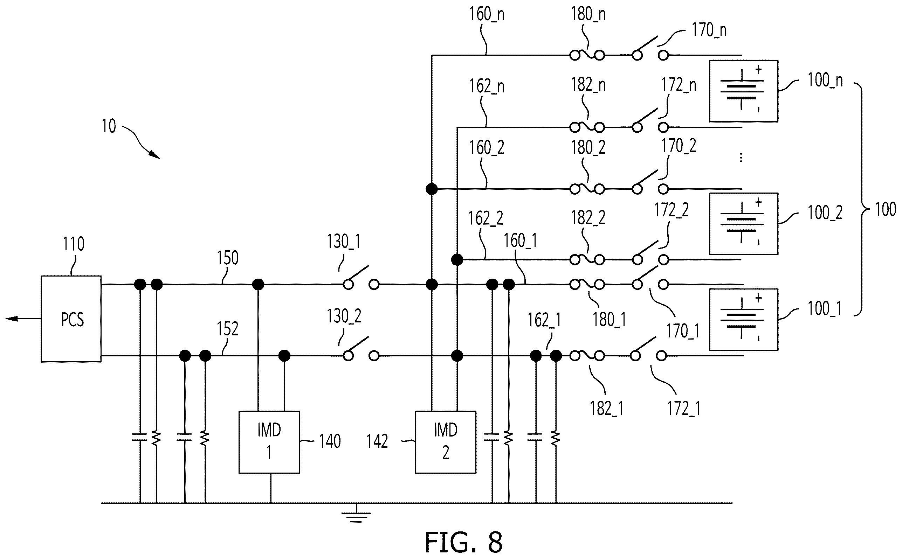

FIG. 8 illustrates a circuit diagram showing a configuration of the energy storage system 10 according to embodiments of the present invention. For ease of explanation, emphasis will be placed on points different from those described with reference to FIGS. 2 and 4.

In embodiments, the energy storage system 10 may further include a plurality of fuses 180 and 182, each connected between a respective one of the plurality of battery racks 100 and the main switch 130. Here, each of the plurality of first fuses 180 may be connected to each of the plurality of sub (+) circuits 160, and each of the plurality of second fuses 182 may be connected to each of the plurality of sub (-) circuits 162. The plurality of fuses 180 and 182 may function as protection devices to prevent damage or accidents caused by overcurrent in the energy storage system 10.

FIG. 9 illustrates a perspective view of a battery rack according to embodiments of the present invention. FIG. 10 illustrates a perspective view of a battery module according to embodiments of the present invention. An energy storage system according to embodiments of the present invention may include a plurality of battery racks 30 that each include a plurality of battery cells 50, connected in parallel. Referring to FIGS. 9 and 10, each of the plurality of battery racks 30 may include a battery module 40 that includes a plurality of battery cells 50. FIG. 9 shows a case in which eight battery modules 40 are housed in the battery rack 30, but this is merely an example, and one or more battery modules 40 may be housed in the battery rack 30. The battery rack 30 described in FIGS. 9 and 10 may correspond to the battery rack 100 described herein.

The battery module 40 may be an assembly in which a plurality of battery cells 50 are connected in series or parallel, and it may include a plurality of battery cells 50 and a frame that accommodates them. The battery module 40 may connect the plurality of battery cells 50 in series by means of a plurality of connection terminals. One connection terminal may electrically connect a negative terminal of one battery cell 50 to a positive terminal of another battery cell 50. In this way, the plurality of battery cells 50 may be connected in series. However, the present invention is not limited thereto, and the plurality of battery cells 50 may be connected in parallel or in a combination of both series and parallel via the connection terminals. The plurality of battery cells 50 may be housed in the battery module 40 in multiple columns.

The frame of the battery module 40 may accommodate and protect the battery cells 50, and may be detachably fixed to the battery rack 30. For example, the battery rack 30 may be a cabinet that houses eight battery modules 40. According to embodiments, the energy storage system may include at least one battery rack 30, and the plurality of battery racks 30 may be electrically connected to one another. The battery rack 30 may have its high-power terminals (positive and negative) exposed outwardly, and the high-power terminals of each battery rack 30 may be connected in parallel. The battery rack 30 may include the plurality of battery modules 40 in which the plurality of battery cells 50 are electrically connected. Each battery rack 30 may include a plurality of battery modules 40 that are electrically connected in series and/or in parallel. The plurality of battery modules 40 may be housed in the height direction of the battery rack 30. Although not shown, multiple battery racks 30 may be electrically connected to form a battery container. Such a battery container, being an aggregate of a large number of battery cells, may be utilized as an energy storage system for storing and supplying power.

The herein-described preferred embodiments of the present invention are disclosed merely by way of example, and those having ordinary skill in the art will appreciate that various substitutions, modifications, and additions are possible within the scope of the present invention. Such substitutions, modifications, and additions should be considered to fall within the scope of the appended claims.

One of ordinary skill in the art will understand that various substitutions, modifications, and changes can be made without departing from the technical scope of the present invention, so the present invention is not limited by the aforementioned embodiments and the accompanying drawings.

Although the present invention has been described herein with respect to embodiments thereof, the present invention is not limited thereto. Various modifications and variations can be made thereto by those skilled in the art within the scope of the present invention and the equivalent scope of the appended claims.

## Claims

1. An energy storage system (10) comprising:
a plurality of battery racks (100) each comprising a plurality of batteries and connected in parallel with one another;
a power conversion device (110) connected to the plurality of battery racks (100) and configured to convert power;
a main switch (130) configured to turn on and off a current flow between the plurality of battery racks (100) and the power conversion device (110);
a first insulation monitoring device (140) and a second insulation monitoring device (142), each connected to respective terminals of the main switch (130); and
a controller (120) configured to control operations of the main switch (130), the first insulation monitoring device (140), and the second insulation monitoring device (142),
wherein the first insulation monitoring device (140) monitors insulation information regarding the power conversion device (110), and the second insulation monitoring device (142) monitors insulation information regarding the plurality of battery racks (100).

2. The energy storage system (10) according to claim 1, wherein the controller (120) is configured to control one of the first insulation monitoring device (140) and the second insulation monitoring device (142) to operate when the main switch (130) is in a closed state.

3. The energy storage system (10) according to claim 1 or 2, wherein the controller (120) is configured to stop operations of the first insulation monitoring device (140) and the second insulation monitoring device (142) for a predetermined time when closing the main switch (130).

4. The energy storage system (10) according to claim 3, wherein, after the operations of the first insulation monitoring device (140) and the second insulation monitoring device (142) are stopped, the controller (120) is configured to control either the first insulation monitoring device (140) or the second insulation monitoring device (142) to operate after the predetermined time elapses.

5. The energy storage system (10) according to claim 3 or 4, wherein, after the operations of the first insulation monitoring device (140) and the second insulation monitoring device (142) are stopped, the controller (120) is configured to control the second insulation monitoring device (142) to operate after the predetermined time elapses and control the first insulation monitoring device (140) not to operate.

6. The energy storage system (10) according to any of the preceding claims , further comprising a plurality of sub switches (170, 172) each connected to the plurality of battery racks (100) and configured to turn on and off a current flow between the second insulation monitoring device (142) and the plurality of battery racks (100),
wherein each of the plurality of sub switches (170, 172) corresponds to each of the plurality of battery racks (100), and
the controller (120) is further configured to control operations of the plurality of sub switches (170, 172).

7. The energy storage system (10) according to claim 6, wherein, when the main switch (130) is in an open state, the controller (120) is configured to control operations of the plurality of sub switches (170, 172) and the second insulation monitoring device (142) so as to monitor insulation information of each of the plurality of battery racks (100) by sequentially closing the plurality of sub switches (170, 172).

8. The energy storage system (10) according to claim 6 or 7, wherein, if the controller (120) determines that an insulation state of a specific battery rack is abnormal, the controller (120) is configured to control a sub switch connected to the specific battery rack to open.

9. The energy storage system (10) according to claim 7 or 8, wherein, if the controller (120) finishes monitoring insulation information of the plurality of battery racks (100), the controller (120) is configured to control the main switch (130) to close.

10. The energy storage system (10) according to any of the preceding claims, further comprising a plurality of fuses (180, 182) each connected between a respective one of the plurality of battery racks (100) and the main switch (130).

11. The energy storage system (10) according to any of the preceding claims , further comprising:
a main positive circuit (150) in which positive output terminals of the plurality of battery racks (100) are connected in parallel; and
a main negative circuit (152) in which negative output terminals of the plurality of battery racks (100) are connected in parallel,
wherein the main positive circuit (150) and the main negative circuit (152) are connected to the main switch (130).

12. The energy storage system (10) according to claim 11, further comprising:
a plurality of sub positive circuits (160) branched from the main positive circuit (150) and connected respectively to the positive output terminals of each of the plurality of battery racks (100); and
a plurality of sub negative circuits (162) branched from the main negative circuit (152) and connected respectively to the negative output terminals of each of the plurality of battery racks (100),
wherein each of the plurality of sub positive circuits (160) is connected to a first sub switch (170), and each of the plurality of sub negative circuits (162) is connected to a second sub switch (172).

13. The energy storage system (10) according to claim 11 or 12, further comprising:
a plurality of sub positive circuits (160) branched from the main positive circuit (150) and connected respectively to the positive output terminals of each of the plurality of battery racks (100); and
a plurality of sub negative circuits (162) branched from the main negative circuit (152) and connected respectively to the negative output terminals of each of the plurality of battery racks (100),
wherein each of the plurality of sub positive circuits (160) is connected to a first fuse (180), and each of the plurality of sub negative circuits (162) is connected to a second fuse (182).

14. An insulation monitoring method (S300) of an energy storage system (10) including a plurality of battery racks (100), the insulation monitoring method (S300) comprising:
monitoring (S310) an insulation state of a power conversion device (110) that converts power by controlling operation of a first insulation monitoring device (140);
monitoring (S320) an insulation state of the plurality of battery racks (100) by controlling operation of a second insulation monitoring device (142);
closing (S330) a main switch (130), which is connected between the plurality of battery racks (100) and the power conversion device (110), in response to determining that the insulation states of the power conversion device (110) and the plurality of battery racks (100) are normal; and
controlling (S340) one of the first insulation monitoring device (140) or the second insulation monitoring device (142) to operate.

15. The insulation monitoring method (S300) according to claim 14, wherein the energy storage system (10) further comprises a plurality of sub switches (170, 172) each connected to the plurality of battery racks (100) and configured to turn on and off a current flow between the second insulation monitoring device (142) and the plurality of battery racks (100).
